# EUROPEAN PATENT APPLICATION

(11) **EP 2 482 451 A1**
(43) Date of publication of application: **01.08.2012**
(21) Application number: 10818818.6
(22) Date of filing: 22.09.2010
(51) Int. Cl.: H03H 9/145, H03H 9/25, H03H 9/64

(54) **SURFACE ACOUSTIC WAVE DEVICE**

(30) Priority: 25.09.2009 JP 2009220910
(71) Applicant: Murata Manufacturing Co., Ltd., Kyoto 617-8555 (JP)
(72) Inventor: KADOTA, Michio, Nagaokakyo-shi Kyoto 617-8555 (JP)
(74) Representative: Thévenet, Jean-Bruno
(86) International application number: PCT/JP2010/066426
(87) International publication number: WO 2011/037145

(57) **Abstract**

To provide a surface acoustic wave device in which an increase in the acoustic velocity and an increase in the electromechanical coupling coefficient k² of surface acoustic waves can be achieved and the reflection coefficient can be further increased. A surface acoustic wave device (1) has a piezoelectric substrate having an R-plane, a-plane, or m-plane sapphire substrate (2a) and a LiNbO₃ film (2b) of (90°, 90°, -15° to 15°) or (0°, 90°, -15° to 15°) in terms of Euler angles (φ, 0, Ψ) formed on the sapphire substrate (2a), and electrodes (3) formed on the piezoelectric substrate and made of metal.

## Description

### Technical Field

The present invention relates to a surface acoustic wave device for use in a resonator a band-pass filter, and the like and more specifically relates to a surface acoustic wave device employing a piezoelectric substrate in which an epitaxial LiNbO₃ film is laminated on a sapphire substrate.

### Background Art

In recent years, an increase in frequency has been required also in surface acoustic wave devices with an increase in frequency in communication apparatuses and the like. Moreover, in a surface acoustic wave filter and the like, an increase in band has also been strongly required.

In order to achieve an increase in frequency and an increase in band, it has been required that the acoustic velocity and the electromechanical coupling coefficient k² of surface acoustic waves are high.

In order to satisfy the above-described requirements, Patent Literature 1 discloses a surface acoustic wave device 1001 illustrated in Fig. 32.

The surface acoustic wave device 1001 employs a piezoelectric substrate 1004 in which a (100) LiNbO₃ film 1003 is laminated on a (012) sapphire substrate 1002. On the piezoelectric substrate 1004, input electrodes 1005 and output electrodes 1006 are provided. The projector direction of the c axis on the sapphire substrate 1002 and the c axis direction of the LiNbO₃ film 1003 are parallel to each other. Therefore, it is disclosed that the acoustic velocity and the electromechanical coupling coefficient k² of surface acoustic waves can be increased by controlling the propagation direction of the surface acoustic waves.

In contrast, Patent Literature 2 discloses a surface acoustic wave device employing a piezoelectric substrate in which a (012) LiNbO₃ film is laminated on a (012) sapphire substrate or a piezoelectric substrate in which a (100) LiNbO₃ film is laminated on a (012) sapphire substrate.

### Citation List

### Patent Literature

Patent Literature 1: Japanese Unexamined Patent Application Publication No. 10-322158
Patent Literature 2: International Publication No. WO98/56109

### Summary of Invention

### Technical Problem

According to the surface acoustic wave device disclosed in Patent Literature 1 or Patent Literature 2, an increase in the velocity or an electromechanical coupling coefficient of surface acoustic waves has been achieved by the use of the piezoelectric substrate in which the (100) LiNbO₃ film or the (012) LiNbO₃ film is laminated on the (012) sapphire substrate, i.e., R-plane sapphire substrate. However, in recent years, a further increase in frequency or a further increase in band has been required, and thus an increase in the acoustic velocity and the electromechanical coupling coefficient k² of surface acoustic waves has been more strongly demanded.

Moreover, in order to achieve a reduction in the size of surface acoustic wave devices, an increase in a reflection coefficient has also been strongly demanded.

It is an object of the invention to provide a surface acoustic wave device in which the acoustic velocity and the electromechanical coupling coefficient k² of surface acoustic waves can be further increased and moreover a reflection coefficient can be increased as compared with conventional surface acoustic wave devices in view of the present circumstances of the former techniques described above.

### Solution to Problem

The present inventors have constantly examined in order to achieve an increase in the velocity of surface acoustic waves in a surface acoustic wave device. As a result, the present inventors have found that when a sapphire substrate of a specific crystal orientation and a LiNbO₃ film of a specific crystal orientation are combined in a configuration employing a piezoelectric substrate in which a LiNbO₃ film is laminated on an R-plane, a-plane, or m-plane sapphire substrate, the acoustic velocity of surface acoustic waves is effectively increased, and thus have accomplished the present invention.

More specifically, a person skilled in the art cannot imagine increasing the acoustic velocity of surface acoustic waves by the use of the above-described specific sapphire substrate and the above-described specific LiNbO₃ film when the present application was filed, and the acoustic velocity of surface acoustic waves cannot be effectively increased without using the specific combination of the invention.

According to a wide aspect of the invention, a surface acoustic wave device is provided which has: a piezoelectric substrate having an R-plane, a-plane, or m-plane sapphire substrate and a LiNbO₃ film of (90°, 90°, -15° to 15°) in terms of Euler angles (φ, θ, Ψ) formed on the sapphire substrate; and electrodes formed on the piezoelectric substrate and made of metal.

In a specific aspect of the surface acoustic wave device according to the invention, a primary order mode of a surface acoustic wave is utilized, and when the wavelength of the surface acoustic wave is defined as λ, the LiNbO₃ film thickness is in the range of 0.1 λ to 1.6 λ and preferably in the range of 0.15 λ to 0.9 λ when the Euler angle Ψ is -5° or more and +5° or lower, i.e., in the range of 0° ± 5° and is in the range of 0.18 λ to 0.75 λ when Ψ is -15° or more and lower than -5° or larger than +5° and +15° or lower. Thus, the acoustic velocity of the surface acoustic waves can be further increased and the electromechanical coupling coefficient k² can be further increased.

In another specific aspect of the surface acoustic wave device according to the invention, a secondary order mode of a surface acoustic wave is utilized, and when the wavelength of the surface acoustic wave is defined as λ, the LiNbO₃ film thickness is in the range of 0.4 λ to 1.6 λ and preferably in the range of 0.6 λ to 1.6 λ when the Euler angle Ψ is -5° to 5°.

In another specific aspect of the surface acoustic wave device according to the invention, a tertiary order mode of a surface acoustic wave is utilized, and when the wavelength of the surface acoustic wave is defined as λ, the LiNbO₃ film thickness is in the range of 0.6 λ to 1.6 λ when the Euler angle Ψ is -5° to 5°. In this case, by utilizing the tertiary order mode, a further increase in frequency can be achieved and a further increase in the acoustic velocity and the electromechanical coupling coefficient k² of the surface acoustic waves can be achieved.

In another specific aspect of the surface acoustic wave device according to the invention, the electrodes are made of Al, and when the wavelength of the surface acoustic waves is defined as λ, the thickness of the electrodes made of Al is in the range of 0.02 λ to 0.16 λ. In this case, the electromechanical coupling coefficient k² can be further increased and the reflection coefficient can be increased.

In another specific aspect of the surface acoustic wave device according to the invention, the metallization ratio of the electrodes is in the range of 0.2 to 0.7. Thus, the reflection coefficient can be further increased and the electromechanical coupling coefficient k² can be increased.

In another wide aspect of the invention, a surface acoustic wave device is provided which has: a piezoelectric substrate having an R-plane, a-plane, or m-plane sapphire substrate and a LiNbO₃ film of (0°, 90°, -15° to 15°) in terms of Euler angles (φ, θ, Ψ) formed on the sapphire substrate; and electrodes formed on the piezoelectric substrate and made of metal.

In a specific aspect of the surface acoustic wave device, a primary order mode of a surface acoustic wave is utilized, and when the wavelength of surface acoustic wave is defined as λ, the LiNbO₃ film thickness is in the range of 0.1 λ to 1.6 λ and preferably in the range of 0.12 λ to 1.2 λ when the Euler angle Ψ is -5° or more and +5° or lower and is in the range of 0.17 λ to 0.8 λ when Ψ is -15° or more and lower than -5° or larger than +5° and +15° or lower. In this case, the acoustic velocity and the electromechanical coupling coefficient k² of the surface acoustic waves can be further increased.

In another specific aspect of the surface acoustic wave device according to the invention, a secondary order mode of a surface acoustic wave is utilized, and when the wavelength of the surface acoustic wave is defined as λ, the LiNbO₃ film thickness is in the range of 0.4 λ to 1.6 λ when the Euler angle Ψ is -5° to 5°.

In another specific aspect of the surface acoustic wave device according to the invention, a tertiary order mode of a surface acoustic wave is utilized, and when the wavelength of the surface acoustic wave is defined as λ, the LiNbO₃ film thickness is in the range of 0.6 λ to 1.0 λ when the Euler angle Ψ is -5° to 5°.

In another specific aspect of the surface acoustic wave device according to the invention, the electrodes are made of Al, and when the wavelength of the surface acoustic waves is defined as λ, the thickness of the electrodes made of Al is in the range of 0.02 λ to 0.16 λ and preferably in the range of 0.04 λ to 0.14 λ. In this case, the reflection coefficient can be increased and the electromechanical coupling coefficient k² can be further increased.

In another specific aspect of the surface acoustic wave device provided in the second aspect of the invention, the metallization ratio of the electrodes is in the range of 0.2 to 0.7. In this case, the reflection coefficient can be increased and the electromechanical coupling coefficient k² can be further increased.

In another specific aspect of the surface acoustic wave device according to the invention, a primary order mode of a surface acoustic wave is utilized, and the piezoelectric substrate further has a short circuit electrode between the R-plane, a-plane, or m-plane sapphire substrate and the LiNbO₃ film. Thus, the acoustic velocity can be further increased.

In another specific aspect of the surface acoustic wave device according to the invention, when the wavelength of the surface acoustic wave is defined as λ, the LiNbO₃ film thickness is in the range of 0.15 λ to 1.6 λ and preferably in the range of 0.2 λ to 0.75 λ. Thus, the acoustic velocity can be further increased.

In another specific aspect of the surface acoustic wave device according to the invention, a secondary order mode of surface acoustic wave is utilized, and the piezoelectric substrate further has a short circuit electrode between the R-plane, a-plane, or m-plane sapphire substrate and the LiNbO₃ film. Thus, the acoustic velocity can be further increased.

In another specific aspect of the surface acoustic wave device according to the invention, when the wavelength of the surface acoustic wave is defined as λ, the LiNbO₃ film thickness is in the range of 0.4 λ to 1.6 λ and preferably in the range of 0.6 λ to 1.6 λ. Thus, the acoustic velocity can be further increased. Advantageous Effects of Invention

According to the surface acoustic wave device provided in the first wide aspect, since the piezoelectric substrate in which the LiNbO₃ with Euler angles (90°, 90°, -15° to 15°) is formed on the R-plane, a-plane, or m-plane sapphire substrate is employed, the acoustic velocity of the used surface acoustic waves can be increased and the electromechanical coupling coefficient k² can be sufficiently increased. Therefore, an increase in frequency and an increase in band of the surface acoustic wave device can be achieved.

According to the surface acoustic wave device provided in the second large aspect, since the piezoelectric substrate in which the LiNbO₃ with Euler angles (0°, 90°, -15° to 15°) is formed on the R-plane, a-plane, or m-plane sapphire substrate is employed, the acoustic velocity of the used surface acoustic waves can be increased and the electromechanical coupling coefficient k² can be sufficiently increased. Therefore, an increase in frequency and an increase in band of the surface acoustic wave device can be achieved.

In the following description, LiNbO₃ is abbreviated as LN depending on cases. Brief Description of Drawings

[FIG. 1] FIG. 1 is a front cross sectional view of a surface acoustic wave device according to one embodiment of the invention.
[FIG. 2] FIG. 2 is a view illustrating the relationship between the thickness of a LN film in a piezoelectric substrate containing (90°, 90°, 0°) LN film / (0°, 122°23', 0°) R-plane sapphire and the acoustic velocity of surface acoustic waves.
[FIG. 3] FIG. 3 is a view illustrating the relationship between the thickness of a LN film in a piezoelectric substrate containing (90°, 90°, 0°) LN film/ (0°, 122°23', 0°) R-plane sapphire and a piezoelectric substrate containing (90°, 90°, 0°) LN film / Short circuit electrode / (0°, 122°23', 0°) R-plane sapphire (both structures of FIG. 1 and FIG. 33) and the electromechanical coupling coefficient k².
[FIG. 4] FIG. 4 is a view illustrating the relationship between the thickness of a LN film in a piezoelectric substrate containing (90°, 90°, 5°) LN film / (0°, 122°23', 5°) R-plane sapphire and the acoustic velocity of surface acoustic waves.
[FIG. 5] FIG. 5 is a view illustrating the relationship between the thickness of a LN film in a piezoelectric substrate containing LN (90°, 90°, 5°) film / (0°, 122°23', 5°) R-plane sapphire (structure of FIG. 1) and the electromechanical coupling coefficient k².
[FIG. 6] FIG. 6 is a view illustrating the relationship between the thickness of a LN film in a piezoelectric substrate containing (90°, 90°, Ψ) LN film / (0°, 122°23', Ψ) R-plane sapphire, the propagation direction Ψ, and the acoustic velocity of primary order surface acoustic waves.
[FIG. 7] FIG. 7 is a view illustrating the relationship between the thickness of a LN film in a piezoelectric substrate containing (90°, 90°, Ψ) LN film / (0°, 122°23', Ψ) R-plane sapphire, the propagation direction Ψ, and the electromechanical coupling coefficient k² of primary order surface acoustic waves.
[FIG. 8] FIG. 8 is a view illustrating the relationship between the thickness of a LN film in a piezoelectric substrate containing (0°, 90°, 0°) LN film / (0°, 122°23', 0°) R-plane sapphire and the acoustic velocity of surface acoustic waves.
[FIG. 9] FIG. 9 is a view illustrating the relationship between the thickness of a LN film in a piezoelectric substrate containing LN (0°, 90°, 0°) film / (0°, 122°23', 0°) R-plane sapphire and an electromechanical coupling coefficient k².
[FIG. 10] FIG. 10 is a view illustrating the relationship between the thickness of a LN film in a piezoelectric substrate containing (0°, 90°, 5°) LN film / (0°, 122°23', 5°) R-plane sapphire and the acoustic velocity of surface acoustic waves.
[FIG. 11] FIG. 11 is a view illustrating the relationship between the thickness of a LN film in a piezoelectric substrate containing (0°, 90°, 5°) LN film / (0°, 122°23', 5°) R-plane sapphire and an electromechanical coupling coefficient k².
[FIG. 12] FIG. 12 is a view illustrating the relationship between the thickness of a LN film in a piezoelectric substrate containing (0°, 90°, Ψ) LN film / (0°, 122°23', Ψ) R-plane sapphire, the propagation direction Ψ, and the acoustic velocity of primary order surface acoustic waves.
[FIG. 13] FIG. 13 is a view illustrating the relationship between the thickness of a LN film in a piezoelectric substrate containing (0°, 90°, Ψ) LN film / (0°, 122°23', Ψ) R-plane sapphire, the propagation direction Ψ, and the electromechanical coupling coefficient k² of primary order surface acoustic waves.
[FIG. 14] FIG. 14 is a view illustrating the relationship, in a primary order surface acoustic wave device in which AI film interdigital electrodes are laminated on a piezoelectric substrate containing (90°, 90°, 0°) LN film / (0°, 122°23', 0°) R-plane sapphire, between the thickness of the LN film, the thickness of the Al film interdigital electrodes, and the reflection coefficient.
[FIG. 15] FIG. 15 is a view illustrating the relationship, in a primary order surface acoustic wave device in which AI film interdigital electrodes are laminated on a piezoelectric substrate containing (90°, 90°, 0°) LN film / (0°, 122°23', 0°) R-plane sapphire, between the thickness of the LN film, the thickness of the AI film interdigital electrodes, and the electromechanical coupling coefficient k².
[FIG. 16] FIG. 16 is a view illustrating the relationship, in a primary order surface acoustic wave device in which AI film interdigital electrodes are laminated on a piezoelectric substrate containing (0°, 90°, 0°) LN film / (0°, 122°23', 0°) R-plane sapphire, between the thickness of the LN film, the thickness of the AI film interdigital electrodes, and the reflection coefficient.
[FIG. 17] FIG. 17 is a view illustrating the relationship, in a primary order surface acoustic wave device in which AI film interdigital electrodes are laminated on a piezoelectric substrate containing (0°, 90°, 0°) LN film / (0°, 122°23', 0°) R-plane sapphire, between the thickness of the LN film, the thickness of the AI film interdigital electrodes, and the electromechanical coupling coefficient k².
[FIG. 18] FIG. 18 is a view illustrating the relationship, in a surface acoustic wave device in which the thickness of a LN film is 0.15 λ in a piezoelectric substrate containing (90°, 90°, 0°) LN film / (0°, 122º23', 0°) R-plane sapphire and the thickness of AI film interdigital electrodes formed on the piezoelectric substrate is 0.02 λ, between the metallization ratio of the electrodes and the reflection coefficient.
[FIG. 19] FIG. 19 is a view illustrating the relationship, in a surface acoustic wave device in which the thickness of a LN film is 0.15 λ in a piezoelectric substrate containing (90°, 90°, 0°) LN film / (0°, 122°23', 0°) R-plane sapphire and the thickness of Al film interdigital electrodes formed on the piezoelectric substrate is 0.02 λ, between the metallization ratio of the electrodes and the electromechanical coupling coefficient k².
[FIG. 20] FIG. 20 is a view illustrating the relationship, in a surface acoustic wave device in which the thickness of a LN film is 0.14 λ in a piezoelectric substrate containing (0°, 90°, 0°) LN film / (0°, 122°23', 0°) R-plane sapphire and the thickness of Al film interdigital electrodes formed on the piezoelectric substrate is 0.019 λ, between the metallization ratio of the electrodes and the reflection coefficient.
[FIG. 21] FIG. 21 is a view illustrating the relationship, in a surface acoustic wave device in which the thickness of a LN film is 0.14 λ in a piezoelectric substrate containing (0°, 90°, 0°) LN film / (0°, 122°23', 0°) R-plane sapphire and the thickness of AI film interdigital electrodes formed on the piezoelectric substrate is 0.019 λ, between the metallization ratio of the electrodes and the electromechanical coupling coefficient k².
[FIG. 22] FIG. 22 is a view illustrating the relationship between the thickness of a LN film and the temperature coefficient of frequency TCF in a piezoelectric substrate containing (90°, 90°, 0°) LN film / (0°, 122°23', 0°) R-plane sapphire.
[FIG. 23] FIG. 23 is a view illustrating the relationship between the thickness of a LN film and the temperature coefficient of frequency TCF in a piezoelectric substrate containing (0°, 90°, 0°) LN film / (0°, 122°23', 0°) R-plane sapphire.
[FIG. 24] FIG. 24 is a view illustrating the relationship between the thickness of a LN film in a piezoelectric substrate containing (0°, 90°, 0°) LN film / (0°, 90°, 0°) a-plane sapphire and the acoustic velocity of surface acoustic waves.
[FIG. 25] FIG. 25 is a view illustrating the relationship between the thickness of a LN film in a piezoelectric substrate containing (0°, 90°, 0°) LN film / (0°, 90°, 0°) a-plane sapphire and the electromechanical coupling coefficient k² of surface acoustic waves.
[FIG. 26] FIG. 26 is a view illustrating the relationship between the thickness of a LN film in a piezoelectric substrate containing (90°, 90°, 0°) LN film / (0°, 90°, 0°) a-plane sapphire and the acoustic velocity of surface acoustic waves.
[FIG. 27] FIG. 27 is a view illustrating the relationship between the thickness of a LN film in a piezoelectric substrate containing (90°, 90°, 0°) LN film / (0°, 90°, 0_{°}) a-plane sapphire and the electromechanical coupling coefficient k² of surface acoustic waves.
[FIG. 28] FIG. 28 is a view illustrating the relationship between the thickness of a LN film in a piezoelectric substrate containing (0°, 90°, 0°) LN film / (90°, 90°, 0°) m-plane sapphire and the acoustic velocity of surface acoustic waves.
[FIG. 29] FIG. 29 is a view illustrating the relationship between the thickness of a LN film in a piezoelectric substrate containing (0°, 90°, 0°) LN film / (90°, 90°, 0°) m-plane sapphire and the electromechanical coupling coefficient k² of surface acoustic waves.
[FIG. 30] FIG. 30 is a view illustrating the relationship between the thickness of a LN film in a piezoelectric substrate containing (90°, 90°, 0°) LN film / (90°, 90°, 0°) m-plane sapphire and the acoustic velocity of surface acoustic waves.
[FIG. 31] FIG. 31 is a view illustrating the relationship between the thickness of a LN film in a piezoelectric substrate containing (90°, 90°, 0°) LN film / (90°, 90°, 0°) m-plane sapphire and the electromechanical coupling coefficient k² of surface acoustic waves.
[FIG. 32] FIG. 32 is a perspective view illustrating a former surface acoustic wave device.
[FIG. 33] FIG. 33 is a front cross sectional view of interdigital electrodes /LN film / short circuit electrode / sapphire structure.

### Description of Embodiments

Hereinafter the details of the invention are described.

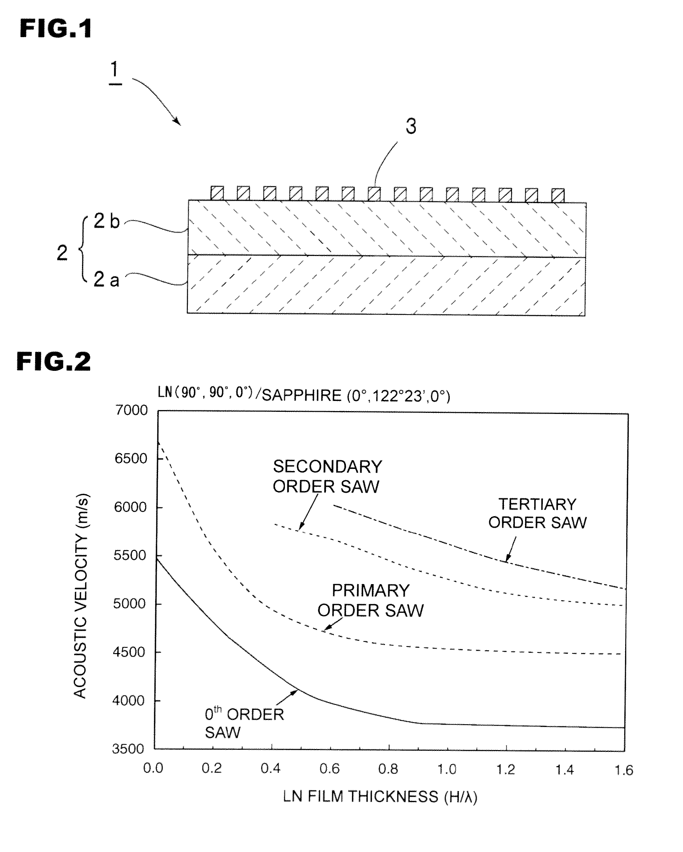

FIG. 1 is a front cross sectional view of a surface acoustic wave device according to one embodiment of the invention. A surface acoustic wave device 1 has a piezoelectric substrate 2. The piezoelectric substrate 2 has an R-plane, a-plane, or m-plane sapphire substrate 2a and a LiNbO₃ film 2b laminated on the R-plane, a-plane, or m-plane sapphire substrate 2a. When the LibO3 film 2b is represented by the Euler angles (φ, θ, Ψ, the LiNbO₃ film 2b is a LiNbO₃ film (90°, 90°, -15° to 15°), or (0°, 90°. -15° to 15°).

On the LiNbO₃ film 2b, electrodes 3 made of metal are formed. The electrodes 3 have at least one interdigital electrode for exciting surface acoustic waves. The structure of the electrodes 3 is not particularly limited and an appropriate electrode structure is provided in accordance with the function of surface acoustic wave devices, such as a surface acoustic wave resonator or a surface acoustic wave filter.

Moreover, an appropriate metal can be used for the material of the electrodes 3, and AI is preferably used. As described later, by adjusting the thickness or the metallization ratio of electrodes made of AI in a specific range, an increase in the acoustic velocity and/or an increase in the reflection coefficient of waves can be achieved.

the configuration and the effects of the above-described surface acoustic wave 1 are clarified based on specific experimental examples.

In the following description, the crystal orientations of the sapphire substrate and the LiNbO₃ are expressed by the Euler angles. The R-plane, sapphire is (0°, 122°23', Ψ) sapphire in terms of the Euler angles, the m-plane sapphire is (90°, 90°, Ψ) in terms of the Euler angles, and the a-plane sapphire is (0°, 90°, Ψ) in terms of the Euler angles.

In order to express the crystal orientation of the sapphire substrate or the LiNbO₃, the Miller index is usually used in addition to the Euler angles. The relationship between the Euler angles and the Miller index is as follows.

R-plane sapphire: Euler angles (0°, 122°23', 0°) = Miller index (012) is established, and is sometimes expressed as (01-12) by the Miller index.

Moreover, there are relationships of Euler angles (90°, 90°, 0°) = Miller index (100) and Euler angles (0°, 90°, 0°) = Miller index (010).

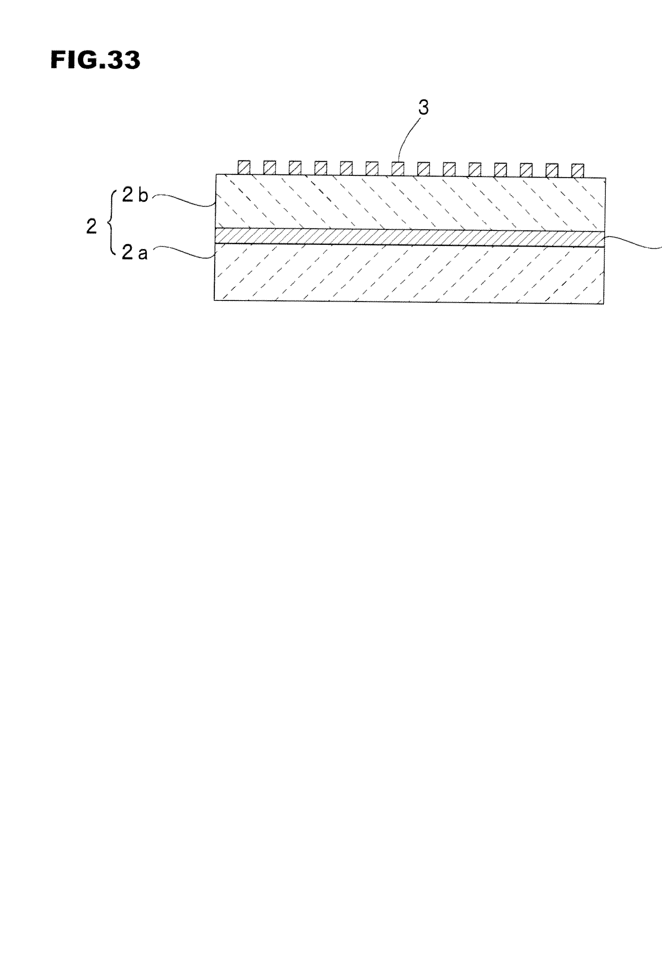

FIG. 33 is a front cross sectional view illustrating the structure of a modification in which a short circuit electrode 4 is inserted between the sapphire substrate 2a and the LiNbO₃ film 2b of the structure of FIG. 1. Herein, the electrode material is AI but metals other than AI may be acceptable insofar as the materials can cause an electrical short circuit.

### [LiNbO₃ / R-plane sapphire]

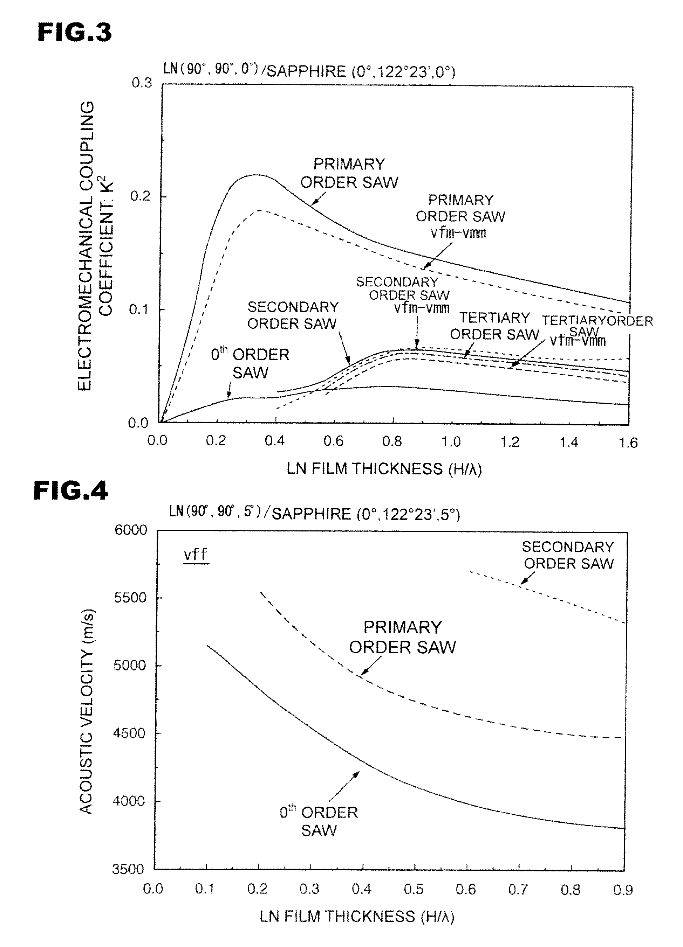

FIG. 2 and FIG. 3 are views illustrating the relationship between the thickness of a LiNbO₃ film when a piezoelectric substrate in which a LiNbO₃ film with Euler angles (90°, 90°, 0°) is laminated on an R-plane sapphire substrate with Euler angles (0°, 122°23', 0°) is and the acoustic velocity of surface acoustic waves and between the thickness and the electromechanical coupling coefficient k² of both structures of FIG. 1 and FIG. 33, respectively. A difference in the electromechanical coupling coefficient k² in the structures of FIG. 1 and FIG. 33 is not so large.

In the following description, LiNbO₃ is abbreviated as a LN film as appropriate.

In the structure in which the electrodes are formed on the piezoelectric substrate, a 0th order surface acoustic wave and primary order, secondary order, and tertiary order surface acoustic waves which are higher order mode surface acoustic waves are excited as illustrated in FIG. 2. As is clear from FIG. 3, when a primary order surface acoustic wave and a secondary order surface acoustic wave are used, a high electromechanical coupling coefficient can be obtained as compared with the case where a 0th order surface acoustic wave is used.

Usually, in a surface acoustic wave device employing a LiNbO₃ substrate, the acoustic velocity is about 4000 m/second. In contrast, FIG. 2 shows that the acoustic velocity of the primary order surface acoustic wave can be considerably increased to about 4600 m/second or more when the thickness of the LN film is below 1.6 λ or lower when (90°, 90°, 0°) LN film / (0°, 122°23', 0°) R-plane sapphire is used. Similarly, also about the secondary order surface acoustic wave, it is found that the acoustic velocity is as high as 5100 m/second or more when the film thickness of the LN film is 1.6 λ or lower, more specifically in the range of 0.4 λ to 1.6 λ. Furthermore, about the tertiary order surface acoustic wave, the acoustic velocity of the surface acoustic wave is considerably increased to 5300 m/second or more when the film thickness of the LN film is in the range of 0.6 λ to 1.6 λ.

Moreover, FIG. 3 shows that when a primary order surface acoustic wave, a secondary order surface acoustic wave, and a tertiary order surface acoustic wave are used, the electromechanical coupling coefficient k² can be increased as compared with the case where a 0th order surface acoustic wave is used, in such a range where the acoustic velocity is high.

Particularly in the case of the primary order surface acoustic wave, it is found that the electromechanical coupling coefficient can be increased as compared with the case of the 0th order surface acoustic wave over the range of the film thickness of the LN film of 0 to 1.6 λ. Preferably, as is understood from FIG. 3, by adjusting the film thickness of the LN film in the range of 0.1 λ to 1.6 λ, the electromechanical coupling coefficient k² can be increased to 0.1 or more. More preferably, by adjusting the film thickness of the LN film in the range of 0.15 λ to 0.9 λ, the electromechanical coupling coefficient k² of 0.15 or more can be achieved.

When the secondary order surface acoustic wave is used, the electromechanical coupling coefficient k² of 0.025 or more can be achieved over the range of the film thickness of the LN film of 0.4 λ to 1.6 λ. More preferably, it is found that, by adjusting the thickness in the range of 0.6 λ to 1.6 λ, the electromechanical coupling coefficient k² of 0.03 or more can be achieved.

It is also found that when the tertiary order surface acoustic wave is used, the electromechanical coupling coefficient k² of 0.03 or more can be achieved by adjusting the film thickness of the LN film to 0.1 λ to 1.6 λ.

FIG. 3 shows the electromechanical coupling coefficient k² of both the structures of the structure of FIG. 1 which is one embodiment of the invention and FIG. 33 which is a modification thereof. The structure of FIG. 33 which is a modification is different from the structure of FIG. 1 which is an embodiment in that a short circuit electrode is provided between the sapphire substrate and the LN film.

In FIG. 3, those represented as the primary order SAW, the secondary order SAW, and the tertiary order SAW represent the electromechanical coupling coefficients k² of the structure of FIG. 1. Those represented as the primary order SAW vfm-vmm, the secondary order SAW vfm-vmm, and tertiary order SAW vfm-vmm represent the electromechanical coupling coefficients k² of the structure of FIG. 33.

As is clear from FIG. 3, it is found that, also in the primary order, the secondary order, and the tertiary order surface acoustic waves of the structure of the modification, the electromechanical coupling coefficient k² which is almost the same as that of the embodiment is obtained by adjusting the film thickness of the LN film to be almost the same as the film thickness of the embodiment.

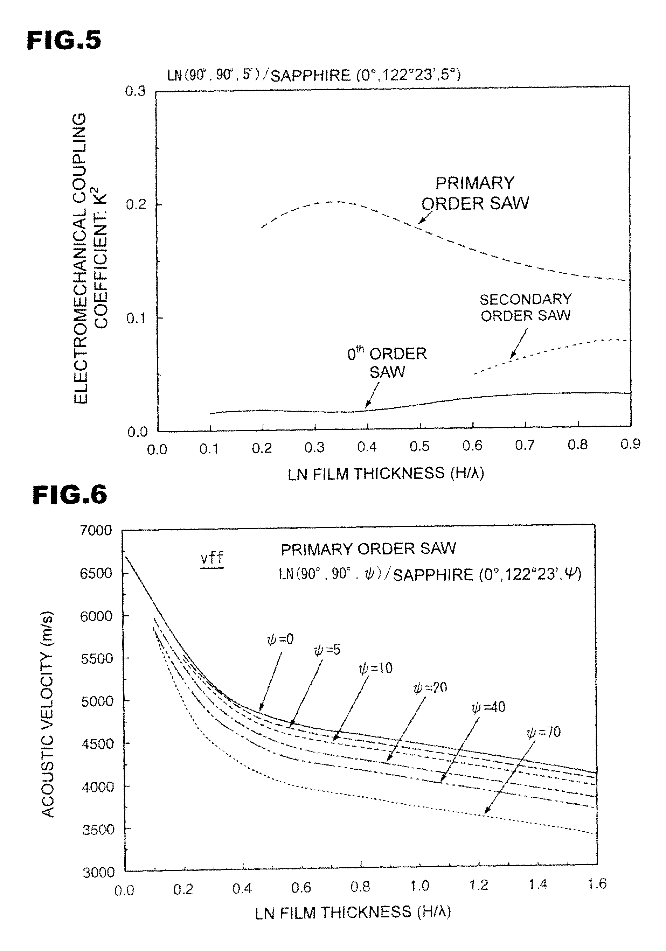

In FIG. 2 and FIG. 3, the Euler angles of the LN film were (90°, 90°, 0°) and the Euler angles of the R-plane sapphire were (0°, 122°23', 0°). The changes in the Euler angles when the propagation direction Ψ was changed were confirmed. FIG. 4 and FIG. 5 are views illustrating the relationship between the thickness of the LN film when the Euler angles of the LN film are (90°, 90°, 5°) and the Euler angles of the R-plane sapphire are (0°, 122°23', 5°) and the acoustic velocity and between the thickness and the electromechanical coupling coefficient k² of surface acoustic waves, respectively.

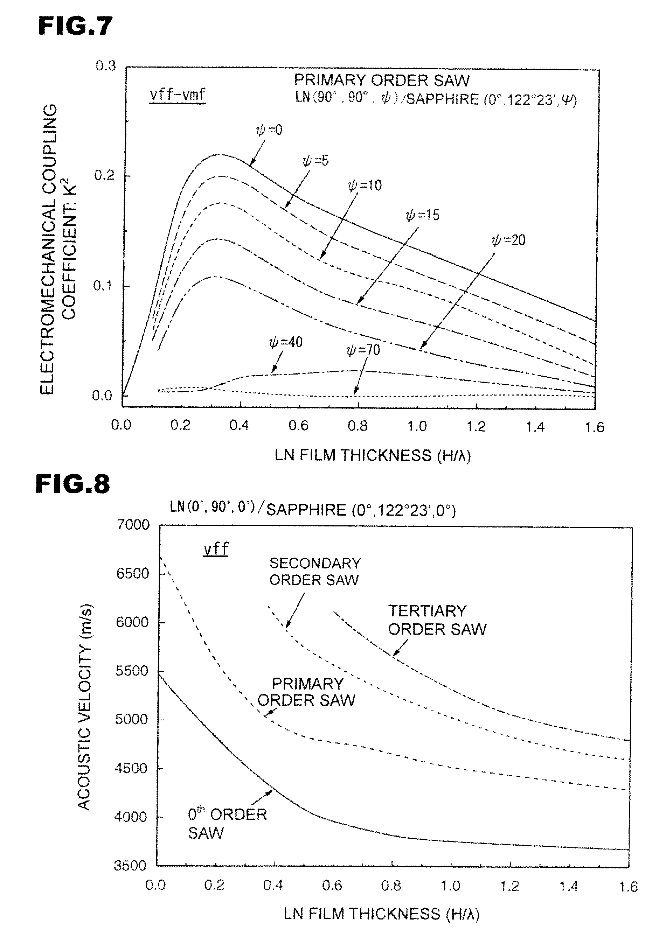

The vff in FIG. 4 refers to the acoustic velocity of surface acoustic waves in the open state in the piezoelectric substrate of the structure of FIG. 1. Similarly, the vff in FIG. 6 and FIG. 7 described below refer to the acoustic velocity in the open state in the piezoelectric substrate of the structure of FIG. 1 and the vmf refers to the acoustic velocity in the short circuit state.

Moreover, the vfm in FIG. 3 refers to the acoustic velocity of surface acoustic waves in the open state in the piezoelectric substrate of the structure of FIG. 33. The vmm refers to the acoustic velocity in the short circuit state in the piezoelectric substrate of the structure of FIG. 33.

As is clear from FIG. 4 and FIG. 5, it is found that, also when the propagation direction Ψ of the Euler angles of the LN film and the R-plane sapphire is changed to 5º from 0°, there is the same tendency as those of FIG. 2 and FIG. 3. Similarly as in FIG. 4 and FIG. 5, the relationship between the thickness of the LN film and the acoustic velocity of surface acoustic waves and the relationship between the thickness and the electromechanical coupling coefficient k² of surface acoustic waves were determined by changing the propagation direction Ψ of the LN film and the propagation direction Ψ of the R-plane sapphire to 0°, 5°, 10°, 20°, 40°, or 70°. The results are shown in FIG. 6 and FIG. 7. As illustrated in FIG. 7, Ψ = 15° is at the midpoint between 10° and 20°.

As is clear from FIG. 6, the acoustic velocity of the surface acoustic waves decreases as an increase in the thickness of the LN film in all of the cases where the propagation direction Ψ is 0°, 5°, 10°, 20°, 40°, or 70°. However, it is found that when the thickness of the LN film is in the range 0.8 λ or lower, the acoustic velocity of the surface acoustic waves can be increased to 4000 m/second in all of the cases.

In particular, it is found that when the thickness of the LN film is in the rage of 0.8 λ or lower, the acoustic velocity of the surface acoustic waves can be increased to 4300 m/second or more when Ψ is lower than 20°, and preferably, by adjusting Ψ to be 10° or lower, the acoustic velocity of the surface acoustic waves can be increased to 4400 m/second or more.

As is clear from FIG. 7, it is found that, by adjusting the propagation direction Ψ to be lower than 20°, a high electromechanical coupling coefficient k² is obtained. Preferably, the propagation direction Ψ is desirably 15° or lower. Thus, the electromechanical coupling coefficient k² can be increased. More preferably, FIG. 7 shows that, by adjusting the propagation direction Ψ to 5° or lower, a high electromechanical coupling coefficient k² can be obtained.

Therefore, as is clear from FIG. 4 to FIG. 7, it is found that, in the lamination structure of the LiNbO₃ with Euler angles (90°, 90°, Ψ) and the sapphire with Euler angles (0°, 122°23', Ψ), when the propagation direction Ψ is lower than 20°, preferably in the range of 15° or lower, and more preferably in the range of 5° or lower, the acoustic velocity of the surface acoustic waves can be increased and the electromechanical coupling coefficient k² can be effectively increased.

More specifically, the electromechanical coupling coefficient k² can be effectively increased by adjusting the film thickness of the LN film in the range of 0.1 λ to 1.6 λ when the Euler angle Ψ is -5° or more and +5° or lower and by adjusting the film thickness in the range of 0.18 λ to 0.75 λ when Ψ is -15° or more and lower than -5° or larger than +5° and +15° or lower.

Even when the propagation direction Ψ is a negative value, the same results when the direction Ψ is a positive value are obtained. Therefore, it is found that the Euler angles of the R-plane sapphire may be in the range of (0°, 122°23', 0° ± 15°), in other words in the range of (0°, 122°23', -15° to 15°), and preferably in the range of (0°, 122°23', -5° to 5°).

### [LN film with Euler angles (0°, 90°, 0°) / R-plane sapphire with Euler angles (0°, 122°23', 0°)]

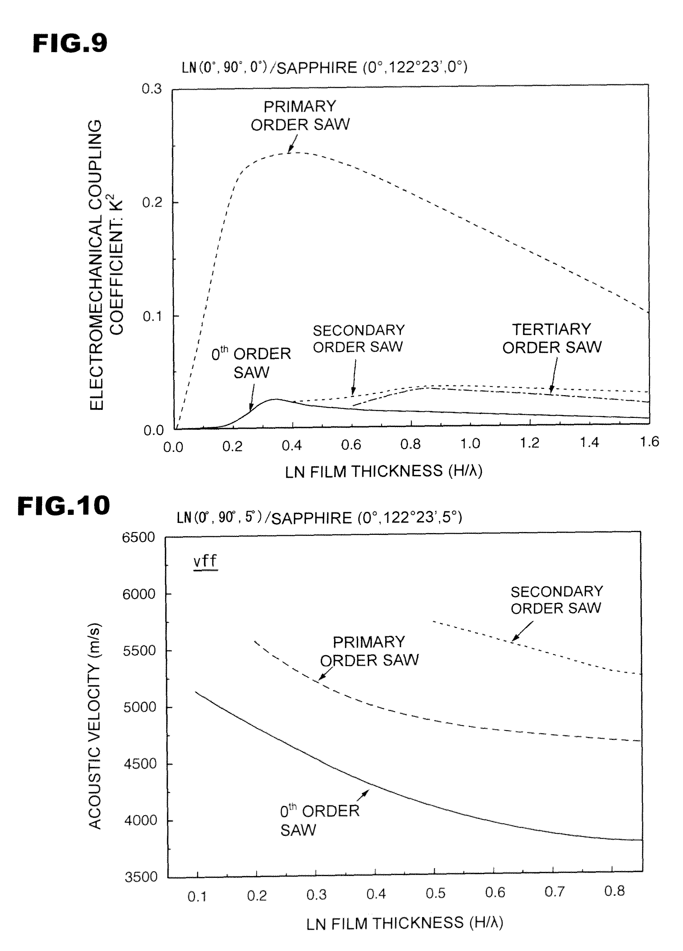

FIG. 8 and FIG. 9 are views illustrating the relationship between the thickness of a LiNbO₃ film in the case of the structure of FIG. 1 employing a piezoelectric substrate in which a LiNbO₃ film with Euler angles (0°, 90°, 0°) is formed on an R-plane sapphire substrate with Euler angles (0°, 122°23', 0°) and the acoustic velocity of surface acoustic waves and between the thickness and the electromechanical coupling coefficient k², respectively.

In the structure in which electrodes are formed on the piezoelectric substrate, a 0th order surface acoustic wave, a primary order surface acoustic wave, a secondary order surface acoustic wave, and a tertiary order surface acoustic wave are excited as illustrated in FIG. 8. As is clear from the drawings, when the primary order surface acoustic wave, the secondary order surface acoustic wave, and the tertiary order surface acoustic wave are used, a high electromechanical coupling coefficient can be obtained as compared with the case where the 0th order surface acoustic wave is used.

Usually, in a surface acoustic wave device employing a LiNbO₃ substrate, the acoustic velocity is about 4000 m/second. In contrast, it is found that, in the case where (0°, 90°, 0°) LN film / (0°, 122°23', 0°) R-plane sapphire is used, the acoustic velocity of the primary order surface acoustic wave can be considerably increased to about 4400 m/second or more over the range of the thickness of the LN film of 1.6 λ or lower. Similarly, also about the secondary order surface acoustic wave, it is found that when the film thickness of the LN film is in the range of 1.6 λ or lower and more specifically in the range of 0.4 λ to 1.6 λ, the acoustic velocity is as high as 5300 m/second or more. With respect to the tertiary order surface acoustic wave, when the film thickness of the LN film is in the range of 0.65 λ to 0.9 λ, the acoustic velocity of the surface acoustic wave is considerably increased to 4900 m/second or more.

FIG. 9 shows that when the primary order surface acoustic wave, the secondary order surface acoustic wave, and the tertiary order surface acoustic wave are used, the electromechanical coupling coefficient k² can be increased us compared with the case where the 0th order surface acoustic wave is used in such a range where the acoustic velocity is high. Particularly in the case of the primary order surface acoustic wave, it is found that the electromechanical coupling coefficient can be increased over the range of the film thickness of the LN film of 0 to 1.6 λ as compared with the case of the 0th order surface acoustic wave. As is understood from FIG. 9, preferably, the electromechanical coupling coefficient k² can be increased to 0.1 or more by adjusting the film thickness of the LN film in the range of 0.1 λ to 1.6 λ and, more preferably, the electromechanical coupling coefficient k² of 0.15 λ or more can be achieved by adjusting the film thickness of the LN film in the range of 0.14 λ to 1.2 λ.

When the secondary order surface acoustic wave is used, the electromechanical coupling coefficient k² can be increased to 0.025 or more by adjusting the film thickness of the LN film in the range of 0.4 λ to 1.6 λ and, more preferably, an electromechanical coupling coefficient k² of 0.03 or more can be achieved by adjusting the film thickness of the LN film in the range of 0.6 λ to 1.6 λ.

It is found that when the tertiary order surface acoustic wave is used, an electromechanical coupling coefficient k² of 0.02 or more can be achieved by adjusting the film thickness of the LN film to 0.6 λ to 1.6 λ.

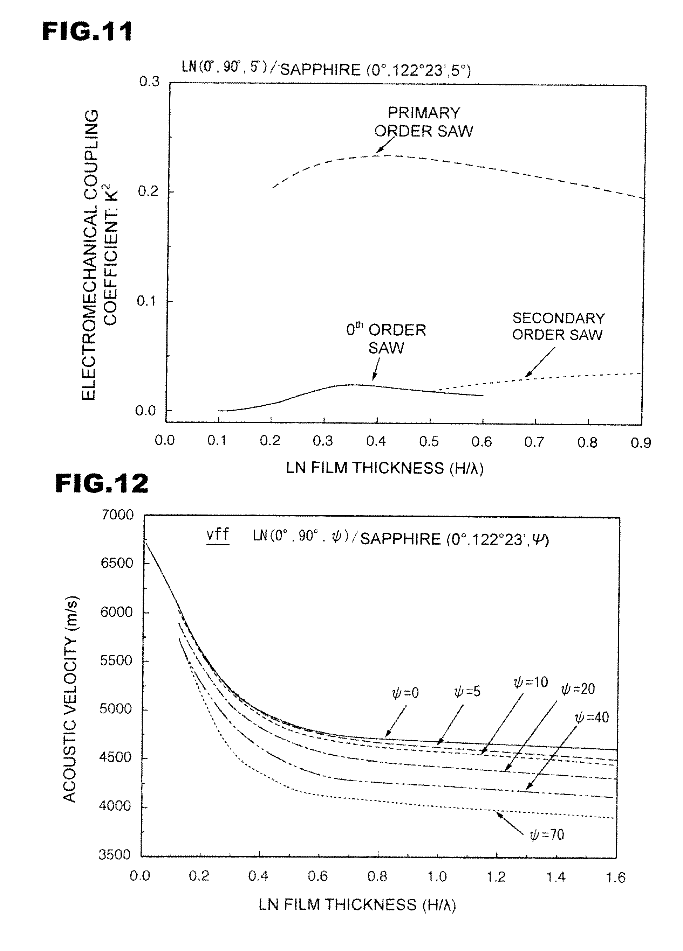

In FIG. 8 and FIG. 9, the Euler angles of the LN film were (0°, 90°, 0°) and the Euler angles of the R-plane sapphire were (0°, 122°23', 0°). Here, it was confirmed how changes would occur when the propagation direction Ψ was changed. FIG. 10 and FIG. 11 are views illustrating the relationship between the thickness of an LN film when the Euler angles of the LN film are (0°, 90°, 5°) and the Euler angles of the R-plane sapphire are (0°, 122°23', 5°) and the acoustic velocity and between the thickness and the electromechanical coupling coefficient k² of surface acoustic waves, respectively.

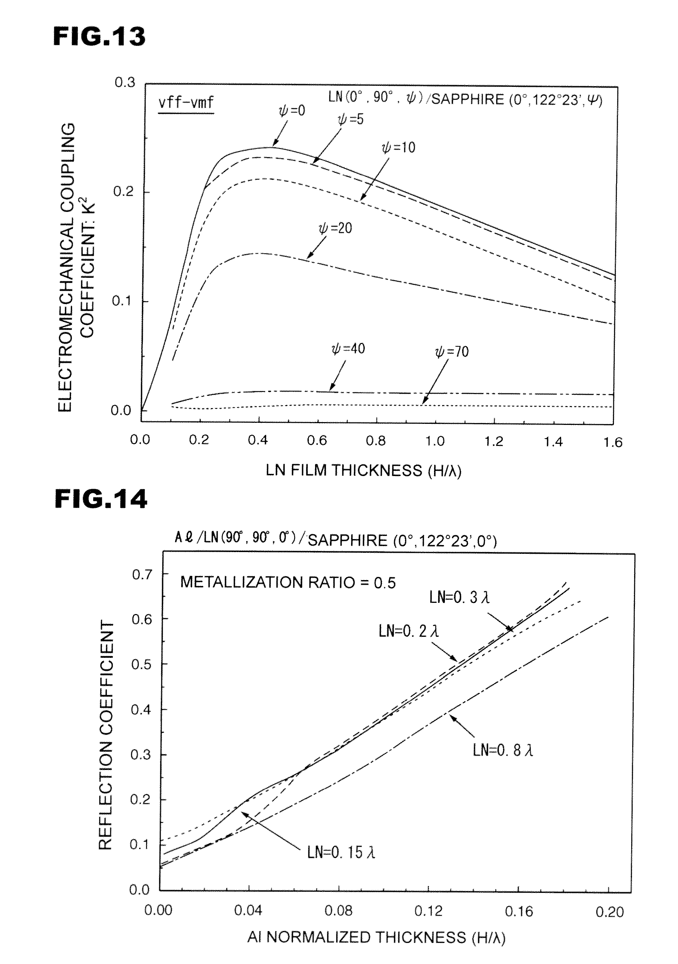

As is clear from FIG. 10 and FIG. 11, it is found that also when the propagation directions Ψ of the Euler angles of the LN film and the R-plane sapphire are changed to 5° from 0°, there is the same tendency as those of FIG. 8 and FIG. 9. Similarly as in FIG. 10 and FIG. 11, the relationship between the thickness of the LN film and the acoustic velocity of surface acoustic waves and the relationship between the thickness and the electromechanical coupling coefficient k² of surface acoustic waves were determined by changing the propagation direction Ψ of the LN film and the propagation direction Ψ of the R-plane sapphire to 0°, 5°, 10°, 20°, 40°, or 70°. The results are shown in FIG. 12 and FIG. 13.

As is clear from FIG. 12, the acoustic velocity of the surface acoustic waves decreases as the thickness of the LN film increases, in all of the cases where the propagation direction Ψ is 0°, 5°, 10°, 20°, 40°, or 70°. However, it is found that when the thickness of the LN film is in the range 0.9 λ or lower, the acoustic velocity of the surface acoustic waves can be increased to 4000 m/second or more in all of the cases. Particularly, it is found that, over the range of the thickness of the LN film of 0.9λ or lower, the acoustic velocity of the surface acoustic waves can be increased to 4400 m/second or more when Ψ is lower than 20° and preferably, by adjusting Ψ to be 10° or lower, the acoustic velocity of the surface acoustic waves can be increased to 4500 m/second or more.

As is clear from FIG. 13, it is found that, by adjusting the propagation direction Ψ to be lower than 20°, a high electromechanical coupling coefficient k² is obtained. Preferably, the propagation direction Ψ is desirably 15° or lower. Thus, the electromechanical coupling coefficient k² can be increased. More preferably, FIG. 7 shows that, by adjusting the propagation direction Ψ to 10° or lower, a high electromechanical coupling coefficient k² can be obtained.

Therefore, as is clear from FIG. 10 to FIG. 13, it is found that, in the lamination structure of the LiNbO₃ with Euler angles (0°, 90°, Ψ) and the sapphire with Euler angles (0°, 122°23', Ψ), when the propagation direction Ψ is lower than 20°, preferably in the range of 15° or lower, and more preferably in the range of 10° or lower, the acoustic velocity of the surface acoustic waves can be increased and the electromechanical coupling coefficient k² can be effectively increased.

Even when the propagation direction Ψ is a negative value, the same results are obtained as when the direction Ψ is a positive value. Therefore, it is found that the Euler angles of the R-plane sapphire may be in the range of (0°, 122°23', 0° ± 15°), in other words in the range of (0°, 122°23', -15° to 15°), and more preferably in the range of (0°, 122°23', -5° to 5°).

More specifically, the electromechanical coupling coefficient k² can be effectively increased by adjusting the film thickness of the LN film in the range of 0.1 λ to 1.6 λ when the Euler angle Ψ is -5° or more and +5° or lower and by adjusting the film thickness in the range of 0.18 λ to 0.75 λ when Ψ is -15° or more and lower than -5°, or larger than +5° and +15° or lower.

### [Thickness of electrodes made of AI and metallization ratio when employing LN film / (0°, 122°23', 0°) R-plane sapphire]

As described above, the present inventors have found that when a piezoelectric substrate in which a LN film with Euler angles (90°, 90°, 0°) or (0°, 90°, 0°) is laminated on an R-plane sapphire with Euler angles (0°, 122°39', -15° to 15°) is used, an increase in the acoustic velocity and an increase in the electromechanical coupling coefficient k² of surface acoustic waves can be achieved. Furthermore, it is found that when AI is used for the electrodes, the reflection coefficient or the electromechanical coupling coefficient k² can be increased by adjusting the thickness of the AI film in a specific range.

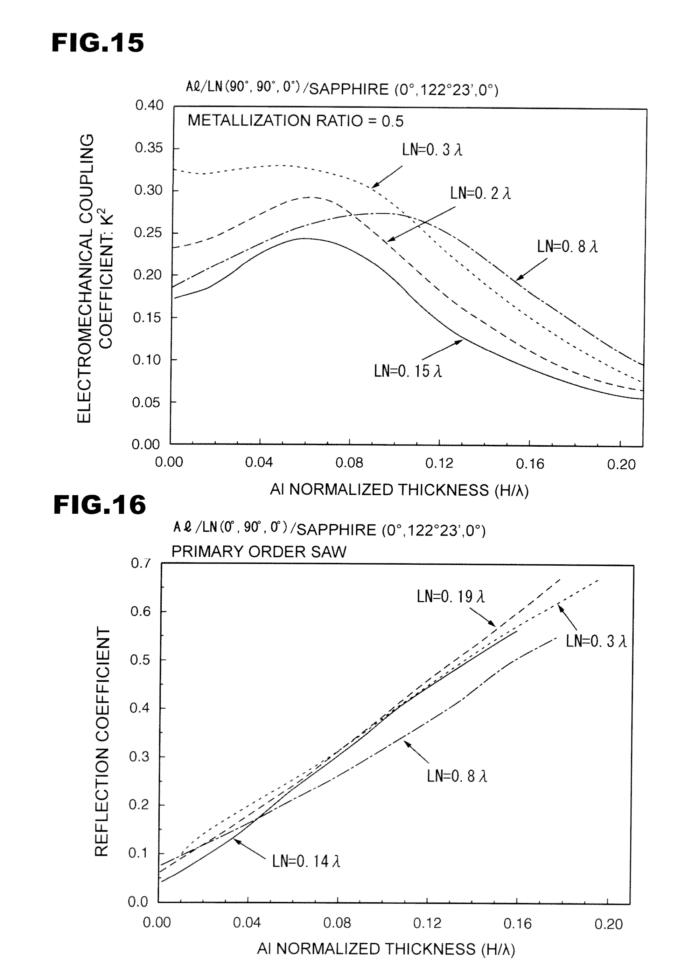

FIG. 14 and FIG. 15 are a view illustrating the relationship, in a surface acoustic wave device in which an AI film is laminated on a piezoelectric substrate containing LN film with Euler angles (90°, 90°, 0°) / R-plane sapphire with Euler angles (0°, 122°23', 0°), between the thickness of the AI film, the thickness of the LN film, and the reflection coefficient and a view illustrating the relationship between the thickness of the Al film, the thickness of the LN film, and the electromechanical coupling coefficient k², respectively. FIG. 14 and FIG. 15 show the results about primary order surface acoustic waves.

In FIG. 14 and FIG. 15, the metallization ratio of the electrodes made of Al was set to 0.5.

As is clear from FIG. 14, it is found that the reflection coefficient becomes higher as the thickness of the Al film increases, in all of the cases where the thickness of the LN film is 0.15 λ, 0.2 λ, 0.3 λ, or 0.8 λ. In particular, FIG. 15 shows that the electromechanical coupling coefficient k² can be made as high as 0.08 or more when the thickness of the Al film is 0.02 λ or more and 0.16 λ or lower.

Therefore, it is found that, in order to obtain a high reflection coefficient of 0.1 or more and an electromechanical coupling coefficient k² of 0.08 or more, the thickness of the Al film may be adjusted in the range of 0.02 λ to 0.16 λ. More preferably, it is found that, by adjusting the thickness of the Al film in the range of 0.04 or more and 0.14 or lower, a reflection coefficient of 0.15 or more can be achieved and an electromechanical coupling coefficient k² of 0.1 or more can be achieved.

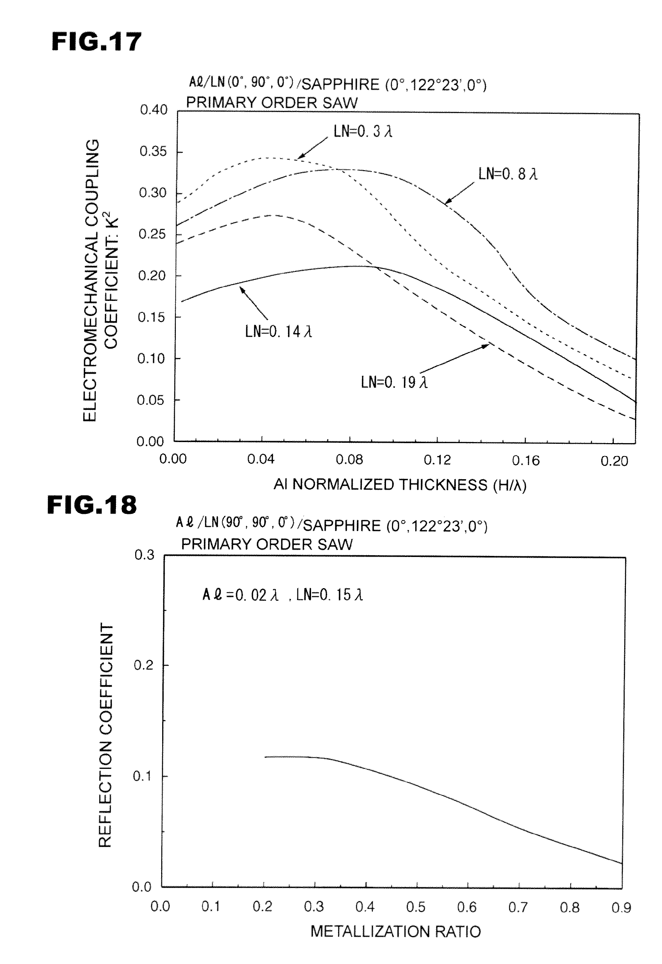

FIG. 16 and FIG. 17 are a view illustrating the relationship, in a surface acoustic wave device in which an Al film is laminated on a piezoelectric substrate containing LN film with Euler angles (0°, 90°, 0°) / R-plane sapphire with Euler angles (0°, 122°23', 0°), between the thickness of the Al film, the thickness of the LN film, and the reflection coefficient and a view illustrating the relationship between the thickness of the Al film, the thickness of the LN film, and the electromechanical coupling coefficient k², respectively. FIG. 16 and FIG. 17 show the results about primary order surface acoustic waves.

In FIG. 16 and FIG. 17, the metallization ratio of the electrodes made of Al was set to 0.5.

As is clear from FIG. 16, it is found that the reflection coefficient becomes higher as the thickness of the Al film in all of the cases where the thickness of the LN film is 0.14 λ, 0.19 λ, 0.3 λ, or 0.8 λ. In particular, FIG. 17 shows that the electromechanical coupling coefficient k² can be made as high as 0.1 or more when the thickness of the Al film is 0.02 λ or more and 0.16 λ or lower.

Therefore, it is found that, in order to obtain a high reflection coefficient of 0.1 and an electromechanical coupling coefficient k² of 0.1 or more, the thickness of the Al film may be adjusted in the range of 0.02 λ to 0.16 λ. More preferably, it is found that, by adjusting the thickness of the Al film in the range of 0.04 λ or more and 0.13 λ or lower, a reflection coefficient of 0.15 or more can be achieved and an electromechanical coupling coefficient k² of 0.15 or more can be achieved.

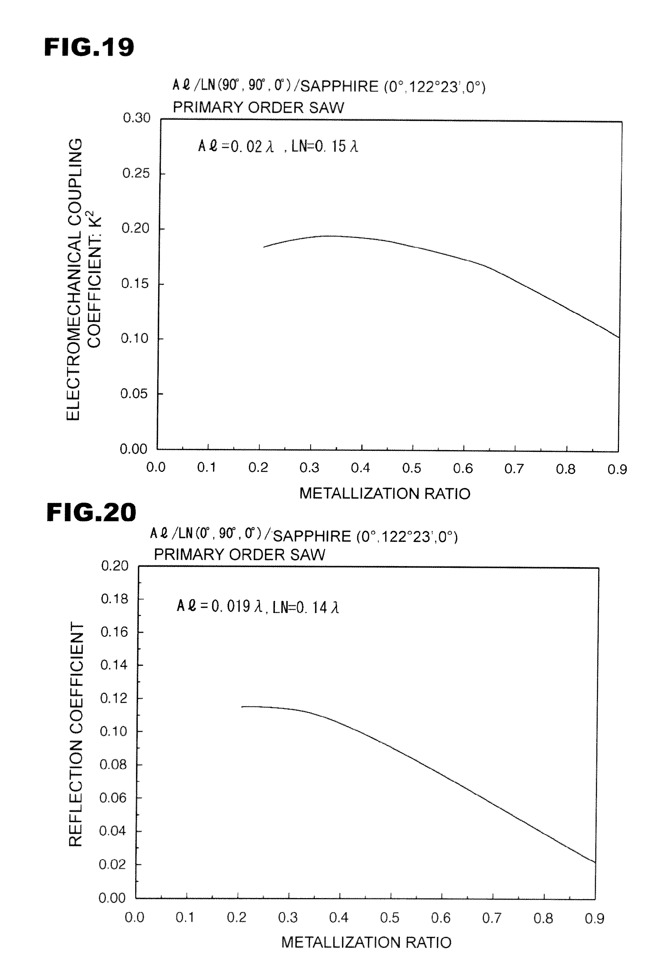

FIG. 18 and FIG. 19 are views illustrating the relationship, in a surface acoustic wave device in which an Al film is 0.15 λ and electrodes made of a 0.02 λ Al film are formed on a piezoelectric substrate containing LN film with Euler angles (90°, 90°, 0°) / R-plane sapphire with Euler angles (0°, 122°23', 0°), between the metallization ratio of the electrodes and the reflection coefficient and between the metallization ratio and the electromechanical coupling coefficient k², respectively.

As is clear from FIG. 18, the reflection coefficient tends to decrease as the metallization ratio increases. Though, as is clear from FIG. 19 and FIG. 18, it is found that, when the metallization ratio is in the range of 0.2 to 0.7, the electromechanical coupling coefficient k² can be made as high as 0.16 or more while increasing the reflection coefficient to 0.06 or more. More specifically, it is found that, by adjusting the metallization ratio in the range of 0.2 to 0.7, the reflection coefficient can be increased and further a sufficient electromechanical coupling coefficient k² can be achieved. More preferably, the metallization ratio is in the range of 0.2 to 0.65. In such a case, it is found that the reflection coefficient can be further increased to 0.07 or more and the electromechanical coupling coefficient k² can be further increased to 0.17 or more.

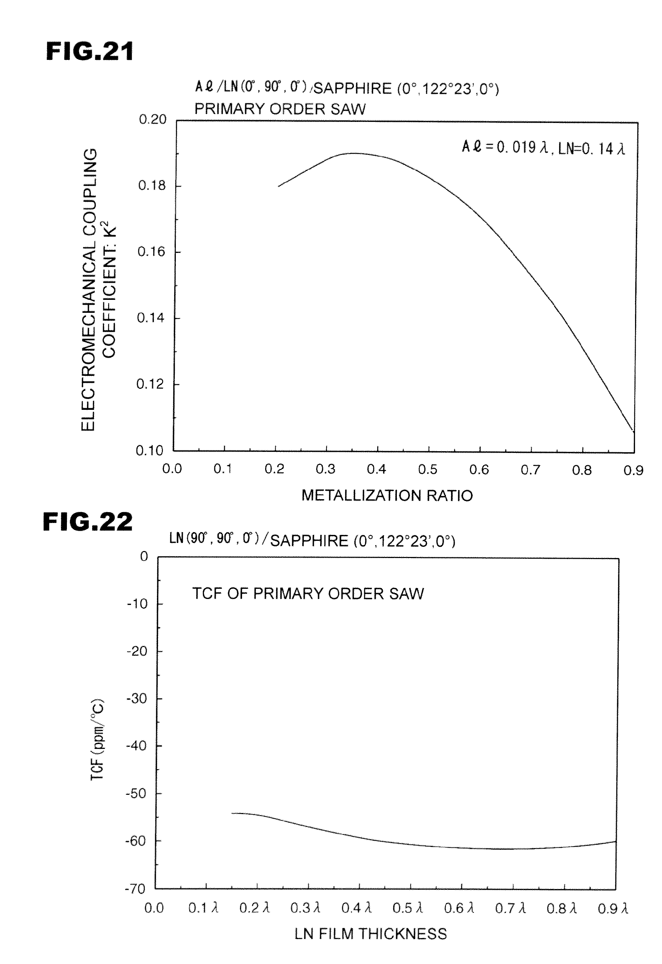

FIG. 20 and FIG. 21 are views illustrating the relationship, in a surface acoustic wave device in which a LN film is 0.14 λ and electrodes made of a 0.019 λ Al film are formed on a piezoelectric substrate containing LN film with Euler angles (0°, 90°, 0°) / R-plane sapphire with Euler angles (0°, 122°23', 0°), between the metallization ratio of the electrodes and the reflection coefficient and between the metallization ratio and the electromechanical coupling coefficient k², respectively.

As is clear from FIG. 20, the reflection coefficient tends to decrease as the metallization ratio increases. Though, as is clear from FIG. 20 and FIG. 21, it is found that, when the metallization ratio is in the range of 0.2 to 0.7, the electromechanical coupling coefficient k² can be made as high as 0.155 or more while increasing the reflection coefficient to 0.06 or more. More specifically, it is found that, by adjusting the metallization ratio in the range of 0.2 to 0.7, the reflection coefficient can be increased and further a sufficient electromechanical coupling coefficient k² can be achieved. More preferably, the metallization ratio is in the range of 0.2 to 0.62. In such a case, it is found that the reflection coefficient can be further increased to 0.07 or more and the electromechanical coupling coefficient k² can be further increased to 0.17 or more.

### [Temperature Coefficient of Frequency, TCF]

FIG. 22 is a view illustrating the relationship between the thickness of a LN film of a piezoelectric substrate containing LN film with Euler angles (90°, 90°, 0°) /R-plane sapphire with Euler angles (0°, 122°23', 0°) and the temperature coefficient of frequency TCF of a primary order surface acoustic wave.

As is clear from FIG. 22, it is found that, even when the film thickness of the LN film is changed in the above-described preferable film thickness range of 0.13 λ to 0.8 λ, the TCF hardly changes. Therefore, it is found that the characteristics hardly change even when the film thickness of the LN film is changed.

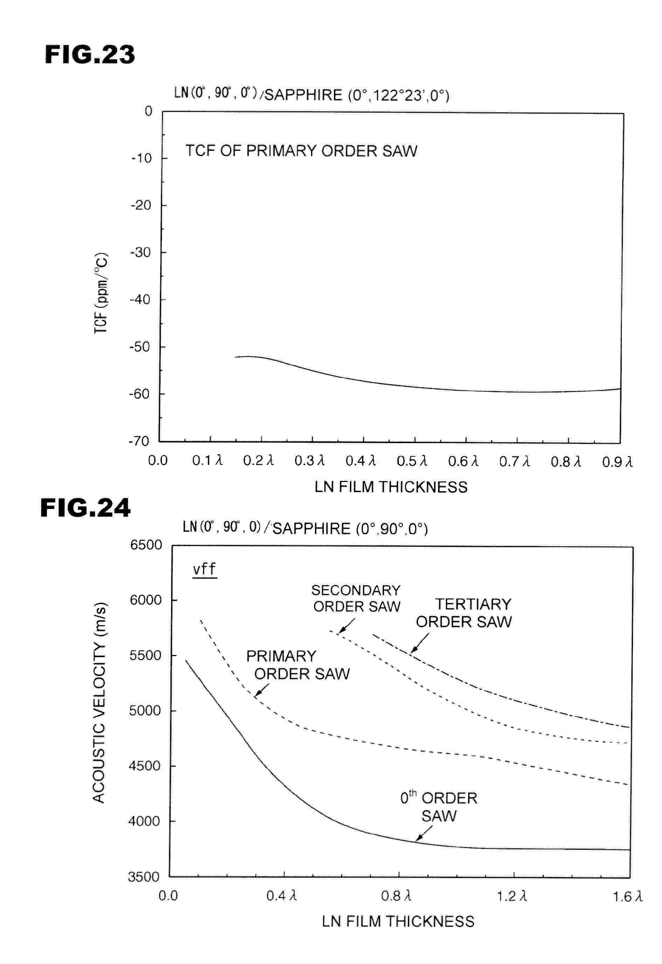

FIG. 23 is a view illustrating the relationship between the thickness of a LN film of a piezoelectric substrate containing LN film with Euler angles (0°, 90°, 0°) /R-plane sapphire with Euler angles (0°, 122°23', 0°) and the temperature coefficient of frequency TCF of a surface acoustic wave.

As is clear from FIG. 23, it is found that, even when the film thickness of the LN film is changed in the above-described preferable film thickness range of 0.13 λ, to 0.8 λ, the TCF hardly changes. Therefore, it is found that the characteristics hardly change even when the film thickness of the LN film is changed.

### [(0°, 90°, 0°) LN film / a-plane sapphire]

The present inventors have found that, even when an a-plane sapphire is used in place of the R-plane sapphire, an increase in the acoustic velocity of surface acoustic waves and an increase in the electromechanical coupling coefficient k² can be achieved by adjusting the crystal orientation of the LN film in a specific direction.

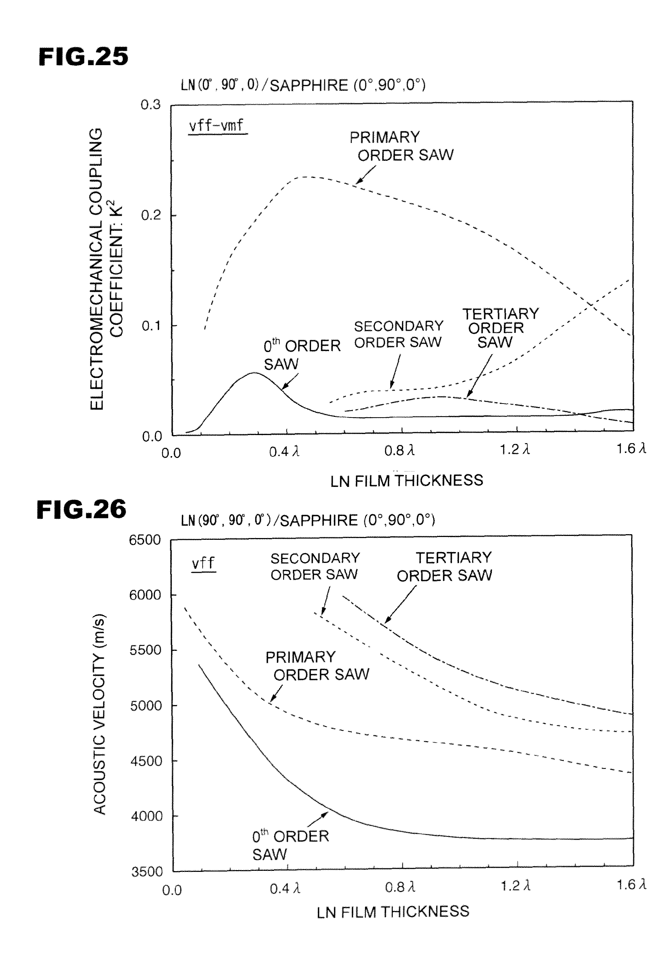

FIG. 24 and FIG. 25 are views illustrating the relationship, in a piezoelectric substrate containing LN film with Euler angles (0°, 90°, 0°) / a-plane sapphire with Euler angles (0°, 90°, 0°), between the thickness of the LN film and the acoustic velocity of surface acoustic waves or the electromechanical coupling coefficient k², respectively.

As is clear from FIG. 24, when primary order, secondary and tertiary order surface acoustic waves are used, the acoustic velocity of the surface acoustic waves can be increased regardless of the film thickness of the LN film when the film thickness of the LN film is in the range 1.6 λ or lower as compared with the case of a 0th order surface acoustic wave.

Over the range of the film thickness of the LN film of 1.6 λ or lower, an acoustic velocity of 4500 m/second or more is obtained in the case of the primary order surface acoustic wave, an acoustic velocity of 4800 m/second or more is obtained in the case of the secondary order surface acoustic wave, and an acoustic velocity of 5100 m/second or more is obtained in the case of the tertiary order surface acoustic wave.

In contrast, as is clear from FIG. 25, it is found that, the electromechanical coupling coefficient k² can be increased to 0.1 or more over the range of the film thickness of the LN film of 0.1 λ or more and 1.6 λ or lower when the primary order surface acoustic wave is used.

Moreover, it is found that when the secondary order surface acoustic wave is used, the electromechanical coupling coefficient k² can be increased to 0.025 or more by adjusting the film thickness of the LN film in the range of 0.5 λ or more and 1.6 λ or lower. It is found that when the tertiary order surface acoustic wave is used, the electromechanical coupling coefficient k² can be increased to 0.02 or more by adjusting the film thickness of the LN film in the range of 0.6 λ or more and 1.6 λ or lower.

### [(90°, 90°, 0°) LN film / a-plane sapphire]

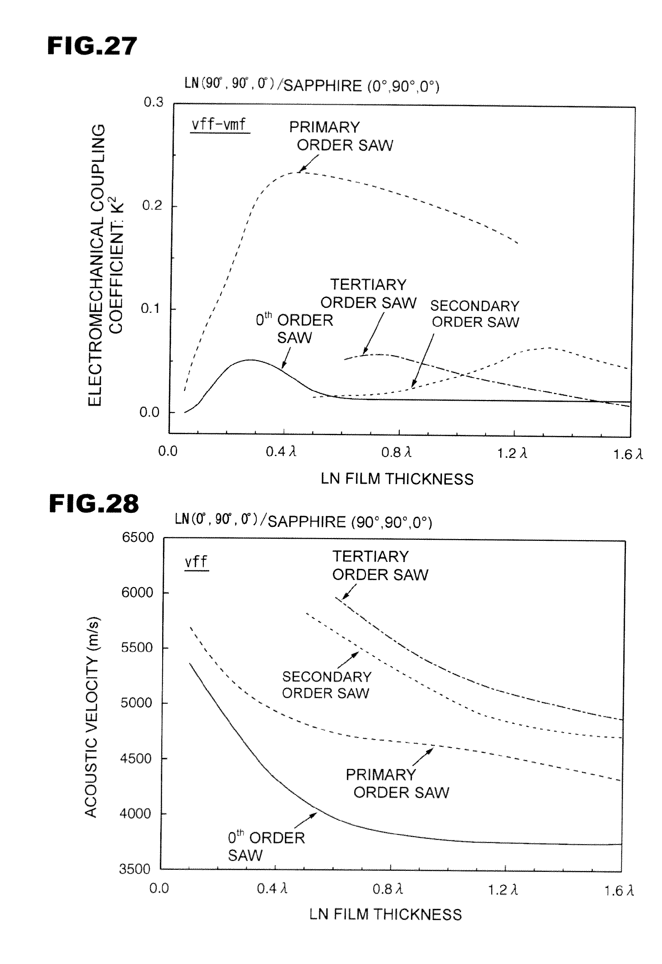

FIG. 26 and FIG. 27 are views illustrating the relationship, in a piezoelectric substrate containing LN film with Euler angles (90°, 90°, 0°) / a-plane sapphire with Euler angles (0°, 90°, 0°), between the thickness of the LN film and the acoustic velocity of surface acoustic waves or between the thickness and the electromechanical coupling coefficient k², respectively.

As is clear from FIG. 26, when primary order, secondary order, and tertiary order surface acoustic waves are used, the acoustic velocity of the acoustic waves can be increased regardless of the film thickness of the LN film when the film thickness of the LN film is in the range 1.6 λ or lower as compared with the case of a 0th order surface acoustic wave.

Over the range of the film thickness of the LN film of 1.6 λ or lower, an acoustic velocity of 4500 m/second or more is obtained in the case of the primary order surface acoustic wave, an acoustic velocity of 4800 m/second or more is obtained in the case of the secondary order surface acoustic wave, and an acoustic velocity of 5100 m/second or more is obtained in the case of the tertiary order surface acoustic wave.

In contrast, as is clear from FIG. 27, it is found that when the primary order surface acoustic wave is used, the electromechanical coupling coefficient k² can be increased to 0.1 or more over the range of the film thickness of the LN film of 0.1 λ or more and 1.6 λ or lower. It is found that when the secondary order surface acoustic wave is used, the electromechanical coupling coefficient k² can be increased to 0.02 or more by adjusting the film thickness of the LN film in the range of 0.05 λ or more and 1.6 λ or lower. It is found that when the tertiary order surface acoustic wave is used, the electromechanical coupling coefficient k² can be increased to 0.02 or more by adjusting the film thickness of the LN film in range of 0.06 λ or more and 1.6 λ or lower

### [(0°, 90°, 0°) LN film / m-plane sapphire]

The present inventors have found that, also in the case where a piezoelectric substrate is used in which a LN film is laminated on an m-plane sapphire, besides the R-plane sapphire or the a-plane sapphire, i.e., a sapphire substrate with Euler angles (90°, 90°, 0°), a high electromechanical coupling coefficient and a high acoustic velocity can be obtained by adjusting the crystal orientation of the LN film in a specific direction.

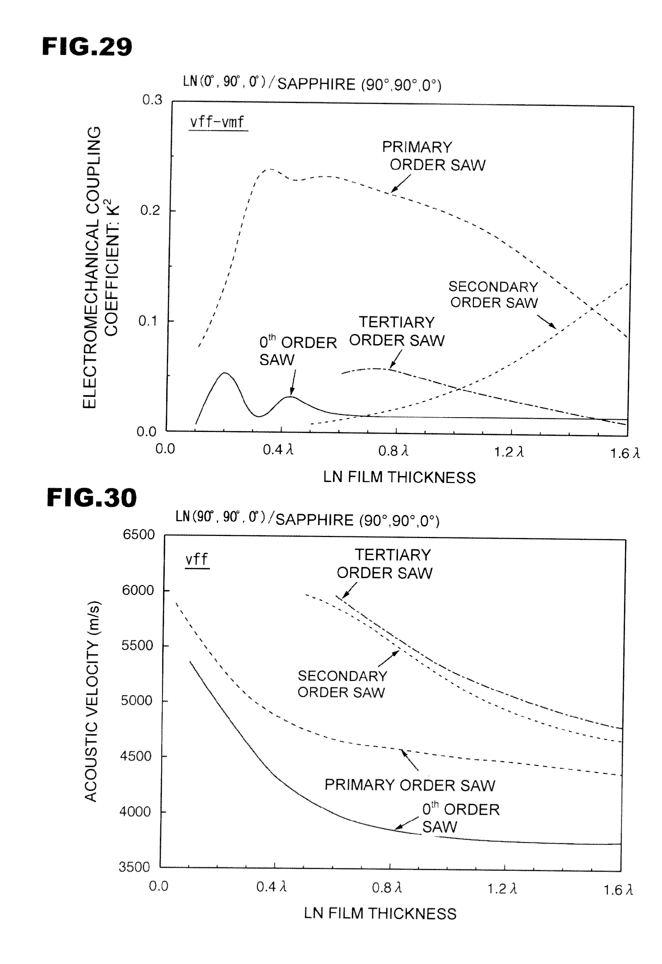

FIG. 28 and FIG. 29 are views illustrating the relationship, in a piezoelectric substrate containing LN film with Euler angles (0°, 90°, 0°) / m-plane sapphire with Euler angles (90°, 90°, 0°), between the thickness of the LN film and the acoustic velocity of surface acoustic waves or between the thickness and the electromechanical coupling coefficient k² of surface acoustic waves, respectively.

As is clear from FIG. 28, when primary order, secondary order, and tertiary order surface acoustic waves are used, the acoustic velocity of the surface acoustic waves can be increased regardless of the film thickness of the LN film when the film thickness of the LN film is in the range 1.6 λ or lower as compared with the case of a 0th order surface acoustic wave.

Over the range of range of the film thickness of the LN film of 1.6 λ or lower, an acoustic velocity of 4500 m/second or more is obtained in the case of the primary order surface acoustic wave, an acoustic velocity of 4800 m/second or more is obtained in the case of the secondary order surface acoustic wave, and an acoustic velocity of 5100 m/second or more is obtained in the case of the tertiary order surface acoustic wave.

In contrast, as is clear from FIG. 29, it is found that the electromechanical coupling coefficient k² can be increased to 0.1 or more over the range of the film thickness of the LN film of 0.1 λ or more and 1.6 λ or lower when the primary order surface acoustic wave is used. Moreover, it is found that when the secondary order surface acoustic wave is used, the electromechanical coupling coefficient k² can be increased to 0.02 or more by adjusting the film thickness of the LN film in the range of 0.5 λ or more and 1.6 λ or lower. It is found that when the tertiary order surface acoustic wave is used, the electromechanical coupling coefficient k² can be increased to 0.015 or more by adjusting the film thickness of the LN film in the range of 0.06 λ or more and 1.6 λ or lower.

### [(90°, 90°, 0°) LN film / m-plane sapphire]

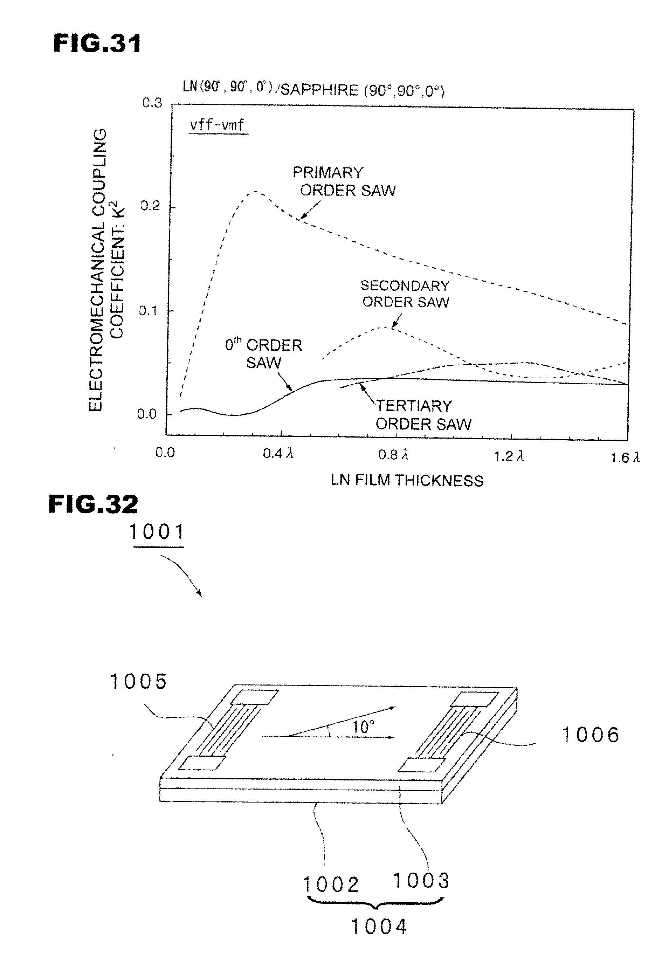

FIG. 30 and FIG. 31 are views illustrating the relationship, in a piezoelectric substrate containing LN film with Euler angles (90°, 90°, 0°) / m-plane sapphire with Euler angles (90°, 90°, 0°), between the thickness of the LN film and the acoustic velocity of surface acoustic waves or between the thickness and the electromechanical coupling coefficient k², respectively.

As is clear from FIG. 30, when primary order, secondary order, and tertiary order surface acoustic waves are used, the acoustic velocity of the surface acoustic waves can be increased regardless of the film thickness of the LN film when the film thickness of the LN film is in the range 1.6 λ or lower as compared with the case of a 0th order surface acoustic wave.

Over the range of range of the film thickness of the LN film of 1.6 λ or lower, an acoustic velocity of 4500 m/second or more is obtained in the case of the primary order surface acoustic wave, an acoustic velocity of 4800 m/second or more is obtained in the case of the secondary order surface acoustic wave, and an acoustic velocity of 5100 m/second or more is obtained in the case of the tertiary order surface acoustic wave.

In contrast, as is clear from FIG. 31, it is found that the electromechanical coupling coefficient k² can be increased to 0.1 or more over the range of the film thickness of the LN film of 0.1 λ or more and 1.6 λ or lower when the primary order surface acoustic wave is used. Moreover, it is found that when the secondary order surface acoustic wave is used, the electromechanical coupling coefficient k² can be increased to 0.04 or more by adjusting the film thickness of the LN film in the range of 0.5 λ or more and 1.6 λ or lower. It is found that when the tertiary order surface acoustic wave is used, the electromechanical coupling coefficient k² can be increased to 0.03 or more by adjusting the film thickness of the LN film in the range of 0.06 λ or more and 1.6 λ or lower.

### Reference Signs List

- 1: SURFACE ACOUSTIC WAVE DEVICE
- 2: PIEZOELECTRIC SUBSTRATE
- 2a: SAPPHIRE SUBSTRATE
- 2b: LiNbO₃ FILM
- 3: ELECTRODE
- 4: SHORT CIRCUIT ELECTRODE

## Claims

1. A surface acoustic wave device, comprising:
a piezoelectric substrate having an R-plane, a-plane, or m-plane sapphire substrate, and
a (90°, 90°, -15° to 15°) LiNbO₃ film in terms of Euler angles (φ, θ, Ψ) formed on the sapphire substrate; and
electrodes formed on the piezoelectric substrate and made of metal.

2. The surface acoustic wave device according to Claim 1, wherein a primary order mode of a surface acoustic wave is utilized, and when the wavelength of the surface acoustic wave is defined as λ, the LiNbO₃ film thickness is in the range of 0.1 λ to 1.6 λ when the Euler angles Ψ is -5° or more and +5° or lower and is in the range of 0.18 λ to 0.75 λ when Ψ is -15° or more and lower than -5° or larger than +5° and +15° or lower.

3. The surface acoustic wave device according to Claim 1, wherein a secondary order mode of a surface acoustic wave is utilized, and when the wavelength of the surface acoustic wave is defined as λ, the LiNbO₃ film thickness is in the range of 0.4 λ to 1.6 λ when the Euler angle Ψ is -5° to 5°.

4. The surface acoustic wave device according to Claim 1, wherein a tertiary order mode of a surface acoustic wave is utilized, and when the wavelength of the surface acoustic wave is defined as λ, the LiNbO₃ film thickness is in the range of 0.6 λ to 1.6 λ when the Euler angle Ψ is -5° to 5°.

5. The surface acoustic wave device according to any one of Claims 1 to 4, wherein the electrodes are made of Al, and when the wavelength of the surface acoustic waves is defined as λ, the thickness of the electrodes made of Al is in the range of 0.02 λ to 0.16 λ.

6. The surface acoustic wave device according to Claim 5, wherein the metallization ratio of the electrodes is in the range of 0.2 to 0.7.

7. A surface acoustic wave device, comprising:
a piezoelectric substrate having an R-plane, a-plane, or m-plane sapphire substrate, and
a (0°, 90°, -15° to 15°) LiNbO₃ film in terms of Euler angles (φ, θ, Ψ) formed on the sapphire substrate; and
electrodes formed on the piezoelectric substrate and made of metal.

8. The surface acoustic wave device according to Claim 7, wherein a primary order mode of a surface acoustic wave is utilized, and when the wavelength of surface acoustic wave is defined as λ, the LiNbO₃ film thickness is in the range of 0.1 λ to 1.6 λ when the Euler angle Ψ is -5° or more and +5° or lower and is in the range of 0.17 λ to 0.8 λ when Ψ is -15° or more and lower than -5° or larger than +5° and +15° or lower.

9. The surface acoustic wave device according to Claim 7, wherein a secondary order mode of a surface acoustic wave is utilized, and when the wavelength of the surface acoustic wave is defined as λ, the LiNbO₃ film thickness is in the range of 0.4 λ to 1.6 λ when the Euler angle Ψ is -5° to 5°,

10. The surface acoustic wave device according to Claim 7, wherein a tertiary order mode of a surface acoustic wave is utilized, and when the wavelength of the surface acoustic wave is defined as λ, the LiNbO₃ film thickness is in the range of 0.6 λ to 1.0 λ when the Euler angle Ψ is -5° to 5°.

11. The surface acoustic wave device according to any one of Claims 7 to 10, wherein the electrodes are made of Al, and when the wavelength of the surface acoustic waves is defined as λ, the thickness of the electrodes made of Al is in the range of 0.02 λ to 0.16 λ.

12. The surface acoustic wave device according to Claim 11, wherein the metallization ratio of the electrodes is in the oaf 0.2 to 0.7.

13. The surface acoustic wave device according to Claim 1, wherein a primary order mode of a surface acoustic wave is utilized, and the piezoelectric substrate further has a short circuit electrode between the R-plane, a-plane, or m-plane sapphire substrate and the LiNbO₃ film.

14. The surface acoustic wave device according to Claim 13, wherein when the wavelength of the surface acoustic wave is defined as λ, the LiNbO₃ film thickness is in the range of 0.15 λ to 1.6 λ

15. The surface acoustic wave device according to Claim 1, wherein a secondary order mode of a surface acoustic wave is utilized, and the piezoelectric substrate further has a short circuit electrode between the R-plane, a-plane, or m-plane sapphire substrate and the LiNbO₃ film.

16. The surface acoustic wave device according to Claim 15, wherein when the wavelength of the surface acoustic wave is defined as λ, the LiNbO₃ film thickness is in the range of 0.4 λ to 1.6 λ and preferably in the range of 0.6 λ to 1.6 λ.
